# EUROPEAN PATENT APPLICATION

(11) **EP 4 496 004 A1**
(43) Date of publication of application: **22.01.2025**
(21) Application number: 23770407.7
(22) Date of filing: 01.03.2023
(51) Int. Cl.: H01L 27/146, H01L 31/10, H04N 25/70

(54) **LIGHT DETECTION DEVICE**

(30) Priority: 15.03.2022 JP 2022040717
(71) Applicant: Sony Semiconductor Solutions Corporation, Atsugi-shi, Kanagawa 243-0014 (JP)
(72) Inventor: FUKUI, Ryo, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/007529
(87) International publication number: WO 2023/176449

(57) **Abstract**

A photodetection apparatus (1) according to the present disclosure includes a photoelectric conversion region (3), a floating diffusion region (4), a ground region (5), and a vertical gate (6). The photoelectric conversion region (3) is provided in a semiconductor layer (2), and converts incident light into signal charges. The floating diffusion region (4) is provided in the semiconductor layer (2), and holds signal charges transferred from the photoelectric conversion region (3). The ground region (5) is provided in the semiconductor layer (2), and connected to the ground. The vertical gate (6) is provided between the floating diffusion region (4) and the ground region (5), extends in the depth direction of the semiconductor layer (2) from a main surface of the semiconductor layer (2) toward the photoelectric conversion region (3), and is configured such that a long surface faces the floating diffusion region (4).

## Description

### Field

The present disclosure relates to a photodetection apparatus.

### Summary

Photodetection apparatuses are provided to detect light by photo-electrically converting incident light into signal charges. A photodetection apparatus is used as, for example, an imaging apparatus. The photodetection apparatus used as an imaging apparatus includes a photoelectric conversion region and a floating diffusion (hereinafter, described as "FD") region and a transfer gate. The photoelectric conversion region and the FD region are provided in a semiconductor layer. The transfer gate transfers signal charges from the photoelectric conversion region to the FD region when a predetermined voltage is applied.

In a conventional photodetection apparatus, the photoelectric conversion region and the FD region are flatly disposed in a surface layer of the semiconductor layer on one main surface side. A transfer gate is provided between the photoelectric conversion region and the FD region on the one main surface in the semiconductor layer.

In recent years, there has been provided a photodetection apparatus including: an FD region provided in a surface layer of a semiconductor layer; a photoelectric conversion region provided at a deeper position of the semiconductor layer than the FD region; and a vertical gate extending from one main surface toward the photoelectric conversion region in a depth direction of the semiconductor layer (for example, see Patent Literature 1).

In the photodetection apparatus including a vertical gate, the photoelectric conversion region and the FD region are disposed in the depth direction of the semiconductor layer, which facilitates achievement of both a saturation signal charge amount and transfer characteristics, and can miniaturize an apparatus.

### Citation List

### Patent Literature

Patent Literature 1: JP 2005-223084 A

### Technical Problem

In a photodetection apparatus including a vertical gate, efficiency of transfer of signal charges from a photoelectric conversion region is improved by expanding the diameter of the vertical gate. When the distance between the vertical gate and an impurity diffusion region such as an FD region and a ground region is shortened by the expansion of the diameter, a strong electric field is generated to cause a dark current irrelevant to incident light, which leads to a white spot appearing in a detection result.

Thus, the present disclosure proposes a photodetection apparatus capable of inhibiting occurrence of a white spot while improving signal charge transfer efficiency.

### Solution to Problem

A photodetection apparatus according to the present disclosure includes a photoelectric conversion region, a floating diffusion region, a ground region, and a vertical gate. The photoelectric conversion region is provided in a semiconductor layer, and converts incident light into signal charges. The floating diffusion region is provided in the semiconductor layer, and holds signal charges transferred from the photoelectric conversion region. The ground region is provided in the semiconductor layer, and connected to the ground. The vertical gate is provided between the floating diffusion region and the ground region, extends in the depth direction of the semiconductor layer from a main surface of the semiconductor layer toward the photoelectric conversion region, and is configured such that a long surface faces the floating diffusion region.

### Brief Description of Drawings

FIG. 1 is a block diagram depicting a schematic configuration example of an imaging apparatus applied to each of embodiments of the present disclosure.
FIG. 2 depicts an example of a stacked structure of the imaging apparatus applied to each of the embodiments of the present disclosure.
FIG. 3 is a circuit diagram depicting an example of a pixel and a readout circuit in FIG. 2.
FIG. 4 is a block diagram depicting a configuration example of an electronic device applied to each of the embodiments of the present disclosure.
FIG. 5A is a schematic plan view of a photodetection apparatus according to a first embodiment.
FIG. 5B is a schematic cross-sectional side view of the photodetection apparatus according to the first embodiment taken along line A-A' in FIG. 5A.
FIG. 5C is a schematic cross-sectional side view of the photodetection apparatus according to the first embodiment taken along line B-B' in FIG. 5A.
FIG. 6 is a schematic plan view of a photodetection apparatus according to a second embodiment.
FIG. 7 is a schematic plan view of a photodetection apparatus according to a third embodiment.
FIG. 8 is a schematic cross-sectional side view of a photodetection apparatus according to a fourth embodiment.
FIG. 9 is a schematic cross-sectional side view of a photodetection apparatus according to a fifth embodiment.
FIG. 10 is a block diagram depicting an example of schematic configuration of a vehicle control system.
FIG. 11 is a diagram of assistance in explaining an example of installation positions of an outside-vehicle information detecting section and an imaging section.
FIG. 12 is a view depicting an example of a schematic configuration of an endoscopic surgery system.
FIG. 13 is a block diagram depicting an example of a functional configuration of a camera head and a camera control unit (CCU). Description of Embodiments

Embodiments of the present disclosure will be described in detail below with reference to the drawings. Incidentally, in each of the following embodiments, the same reference signs are attached to the same parts to omit duplicate description. Although a case where photodetection apparatuses according to the embodiments are imaging apparatuses will be described below, the photodetection apparatuses according to the embodiments can be used as any detection apparatus that detects incident light by photo-electrically converting the incident light into signal charges.

### [1. Common Configuration]

First, configurations of a photodetection apparatus and an electronic device common to the following embodiments will be described in detail with reference to the drawings.

### [1.1. Schematic Configuration Example of Photodetection Apparatus]

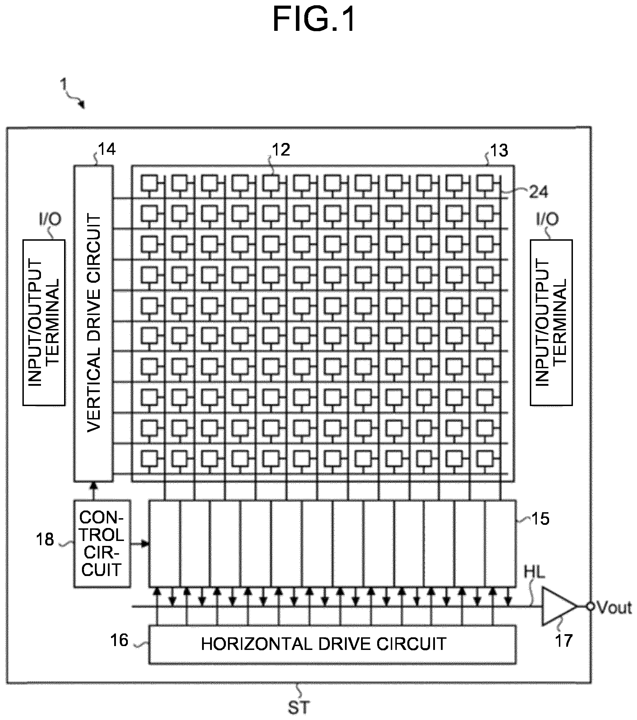

FIG. 1 is a block diagram depicting a schematic configuration example of an imaging apparatus applied to each of the embodiments of the present disclosure. As depicted in FIG. 1, a photodetection apparatus 1 includes a pixel array section (so-called imaging region) 13 and a peripheral circuit section on a semiconductor substrate ST (for example, silicon substrate). In the pixel array section 13, a plurality of pixels 12 including a photoelectric conversion element is regularly and two-dimensionally arranged. A pixel 12 includes, for example, a photodiode serving as a photoelectric conversion element and a plurality of pixel transistors (so-called MOS transistors). The plurality of pixel transistors can include, for example, three transistors of a transfer transistor, a reset transistor, and an amplification transistor. In addition, the plurality of pixel transistors can include four transistors including a selection transistor. Since an equivalent circuit for unit pixels is similar to that in an ordinary case, detailed description will be omitted. The pixel 12 may have a shared pixel structure. The pixel shared structure includes a plurality of photodiodes, a plurality of transfer transistors, one shared floating diffusion, and each one of other shared pixel transistors.

The peripheral circuit section includes a vertical drive circuit 14, column signal process circuits 15, a horizontal drive circuit 16, an output circuit 17, and a control circuit 18.

The control circuit 18 receives an input clock and data for giving a command regarding an operation mode and the like, and outputs data such as information on the inside of the photodetection apparatus. Namely, the control circuit 18 generates clock signals and control signals serving as references of operations of the vertical drive circuit 14, the column signal process circuits 15, and the horizontal drive circuit 16 on the basis of a vertical synchronization signal, a horizontal synchronization signal, and a master clock.
Then, these signals are input to the vertical drive circuit 14, the column signal process circuits 15, the horizontal drive circuit 16, and the like.

The vertical drive circuit 14 includes, for example, a shift register. The vertical drive circuit 14 selects pixel drive wiring, supplies a pulse for driving a pixel to the selected pixel drive wiring, and drives the pixel in units of rows. Namely, the vertical drive circuit 14 sequentially selects and scans each of the pixels 12 of the pixel array section 13 vertically in units of rows. The vertical drive circuit 14 supplies pixel signals based on signal charges to the column signal process circuits 15 through vertical signal lines 24. The signal charges are generated in accordance with received light amounts in, for example, photodiodes serving as photoelectric conversion elements of the respective pixels 12.

The column signal process circuits 15 are arranged for respective columns of the pixels 12, for example. The column signal process circuits 15 perform signal processes such as noise removal on signals output from pixels 12 of one row for each pixel column. Namely, the column signal process circuits 15 perform signal processes such as correlated double sampling (CDS) for removing fixed pattern noise unique to a pixel 12, signal amplification, and AD conversion. A horizontal selection switch (not depicted) is provided between output stages of the column signal process circuits 15 and a horizontal signal line HL. The horizontal selection switch is connected to the horizontal signal line HL.

The horizontal drive circuit 16 includes, for example, a shift register. The horizontal drive circuit 16 selects the respective column signal process circuits 15 in order by sequentially outputting a horizontal scanning pulse, and causes the horizontal signal line HL to output pixel signals from the respective column signal process circuits 15.

The output circuit 17 performs signal processes on the signals sequentially supplied from the respective column signal process circuits 15 through the horizontal signal line HL, and outputs the signals. For example, only buffering may be performed, or black level adjustment, column variation correction, various kinds of digital signal processes, and the like may be performed. An input/output terminal I/O exchanges signals with the outside.

### [1.2. Example of Stacked Structure of Photodetection Apparatus]

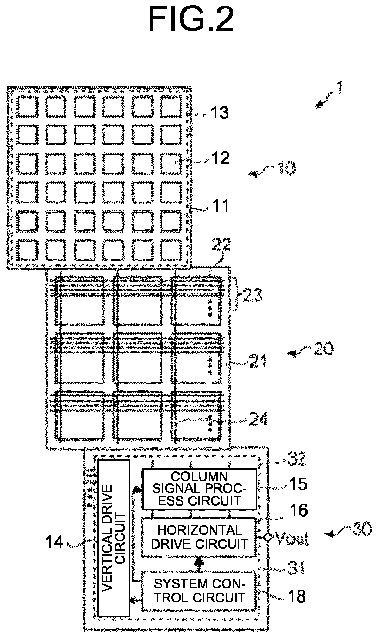

Next, an example of a stacked structure of the photodetection apparatus 1 applied to each of the embodiments of the present disclosure will be described. FIG. 2 depicts the example of the stacked structure of the photodetection apparatus 1 applied to each of the embodiments of the present disclosure. As depicted in FIG. 2, the photodetection apparatus 1 can have a three-dimensional structure formed by bonding three substrates (first substrate 10, second substrate 20, and third substrate 30) together. The first substrate 10, the second substrate 20, and the third substrate 30 are stacked in this order.

The first substrate 10 includes a plurality of pixels 12, which performs photoelectric conversion, on a semiconductor substrate 11. The plurality of pixels 12 is provided in a matrix in the pixel array section 13 on the first substrate 10. The second substrate 20 includes, on a semiconductor substrate 21, readout circuits 22 every four pixels 12. The readout circuits 22 output pixel signals based on charges output from the pixels 12. The second substrate 20 includes a plurality of pixel drive lines 23 extending in a row direction and a plurality of vertical signal lines 24 extending in a column direction. The third substrate 30 includes, on a semiconductor substrate 31, a logic circuit 32 that processes a pixel signal. The logic circuit 32 includes, for example, the vertical drive circuit 14, a column signal process circuit 15, the horizontal drive circuit 16, and the control circuit 18. The logic circuit 32 (specifically, horizontal drive circuit 16) outputs an output voltage Vout for each of the pixels 12 to the outside. In the logic circuit 32, for example, a low resistance region made of silicide formed by using a self-aligned silicide (salicide) process, such as CoSi₂ and NiSi, may be formed on the surface of an impurity diffusion region in contact with a source electrode and a drain electrode.

For example, the vertical drive circuit 14 sequentially selects the plurality of pixels 12 in units of rows. For example, the column signal process circuit 15 performs a CDS process on pixel signals output from respective pixels 12 of a row selected by the vertical drive circuit 14. The column signal process circuit 15 extracts a signal level of a pixel signal by performing the CDS process, for example, and holds pixel data in accordance with a received light amount of each of the pixels 12. For example, the horizontal drive circuit 16 sequentially outputs the pixel data held in the column signal process circuit 15 to the outside. The control circuit 18 controls driving of, for example, respective blocks (vertical drive circuit 14, column signal process circuit 15, and horizontal drive circuit 16) in the logic circuit 32.

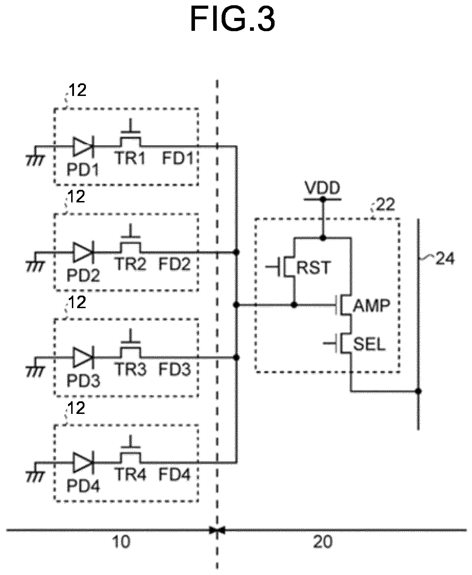

FIG. 3 depicts an example of pixels 12 and the readout circuit 22. A case where four pixels 12 share one readout circuit 22 as depicted in FIG. 3 will be described below. Here, "share" means that outputs of the four pixels 12 are input to the common readout circuit 22.

Each of the pixels 12 has common components. In FIG. 3, in order to distinguish components of the respective pixels 12 from one another, identification numbers (1, 2, 3, and 4) are given to the ends of reference signs of the components of the respective pixels 12. When it is necessary to distinguish components of the respective pixels 12 from one another, identification numbers are given to the ends of reference signs of the components of the respective pixels 12. In contrast, when it is unnecessary to distinguish components of the respective pixels 12 from one another, the identification numbers at the ends of reference signs of the components of the respective pixels 12 will be omitted.

Each of the pixels 12 includes, for example, a photodiode PD, a transfer transistor TR, and a floating diffusion region FD. The transfer transistor TR is electrically connected to the photodiode PD. The floating diffusion region FD temporarily holds charges output from the photodiode PD via the transfer transistor TR. The photodiode PD corresponds to a specific example of a "photoelectric conversion section" of the present disclosure. The photodiode PD performs photoelectric conversion to generate charges in accordance with a received light amount. A cathode of the photodiode PD is electrically connected to a source of the transfer transistor TR. An anode of the photodiode PD is electrically connected to a reference potential line (for example, ground). A drain of the transfer transistor TR is electrically connected to the floating diffusion region FD. A gate of the transfer transistor TR is electrically connected to a pixel drive line 23. The transfer transistor TR is, for example, a CMOS transistor.

Floating diffusion regions FD of respective pixels 12 sharing one readout circuit 22 are electrically and mutually connected, and electrically connected to an input end of the common readout circuit 22. The readout circuit 22 includes, for example, a reset transistor RST, a selection transistor SEL, and an amplification transistor AMP. Incidentally, the selection transistor SEL may be omitted, as necessary. The source (input end of readout circuit 22) of the reset transistor RST is electrically connected to the floating diffusion region FD. A drain of the reset transistor RST is electrically connected to a power supply line VDD and a drain of the amplification transistor AMP. A gate of the reset transistor RST is electrically connected to a pixel drive line 23 (see FIG. 2). A source of the amplification transistor AMP is electrically connected to a drain of the selection transistor SEL. A gate of the amplification transistor AMP is electrically connected to a source of the reset transistor RST. A source (output end of readout circuit 22) of the selection transistor SEL is electrically connected to a vertical signal line 24. A gate of the selection transistor SEL is electrically connected to the pixel drive line 23 (see FIG. 2).

When the transfer transistor TR is turned on, the transfer transistor TR transfers charges of the photodiode PD to the floating diffusion FD. The reset transistor RST resets the potential of the floating diffusion FD to a predetermined potential. When the reset transistor RST is turned on, the potential of the floating diffusion FD is reset to the potential of the power supply line VDD. The selection transistor SEL controls timing of outputting a pixel signal from the readout circuit 22. The amplification transistor AMP generates a signal having a voltage in accordance with a level of charges held in the floating diffusion FD as a pixel signal. The amplification transistor AMP constitutes a source follower type amplifier, and outputs a pixel signal having a voltage in accordance with a level of charges generated in the photodiode PD. When the selection transistor SEL is turned on, the amplification transistor AMP amplifies the potential of the floating diffusion FD, and outputs a voltage in accordance with the potential to the column signal process circuit 15 via the vertical signal line 24. The reset transistor RST, the amplification transistor AMP, and the selection transistor SEL are, for example, CMOS transistors.

### [1.3. Schematic Configuration Example of Electronic Device]

In addition, the above-described photodetection apparatus 1 can be applied to various kinds of electronic devices, such as an imaging system including a digital still camera and a digital video camera, a mobile phone having an imaging function, and other devices having the imaging function.

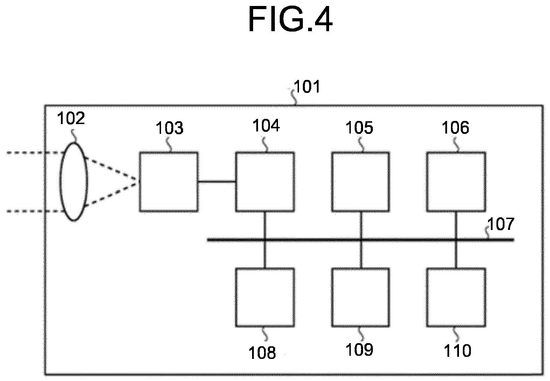

FIG. 4 is a block diagram depicting a configuration example of an electronic device.

As depicted in FIG. 4, an electronic device 101 includes an optical system 102, a photodetection apparatus 103, and a digital signal processor (DSP) 104. The DSP 104, a display apparatus 105, an operation system 106, a memory 108, a recording apparatus 109, and a power supply system 110 are connected via a bus 107. The electronic device 101 can capture a still image and a moving image.

The optical system 102 includes one or a plurality of lenses. The optical system 102 guides image light (incident light) from a subject to the photodetection apparatus 103, and forms an image on a light receiving surface (sensor section) of the photodetection apparatus 103.

The photodetection apparatus 1 in any of the above-described configuration examples is applied as the photodetection apparatus 103. In the photodetection apparatus 103, electrons are accumulated for a certain period in accordance with an image formed on the light receiving surface via the optical system 102. Then, signals in accordance with the electrons accumulated in the photodetection apparatus 103 are supplied to the DSP 104.

The DSP 104 performs various kinds of signal processes on a signal from the photodetection apparatus 103 to acquire an image. The DSP 104 temporarily stores data of the image in the memory 108. The data of the image stored in the memory 108 is recorded in the recording apparatus 109, or supplied to the display apparatus 105 to display the image. In addition, the operation system 106 receives various kinds of operations from a user, and supplies an operation signal to each of blocks of the electronic device 101. The power supply system 110 supplies power necessary for driving each of the blocks of the electronic device 101.

### [2. Photodetection Apparatus According to First Embodiment]

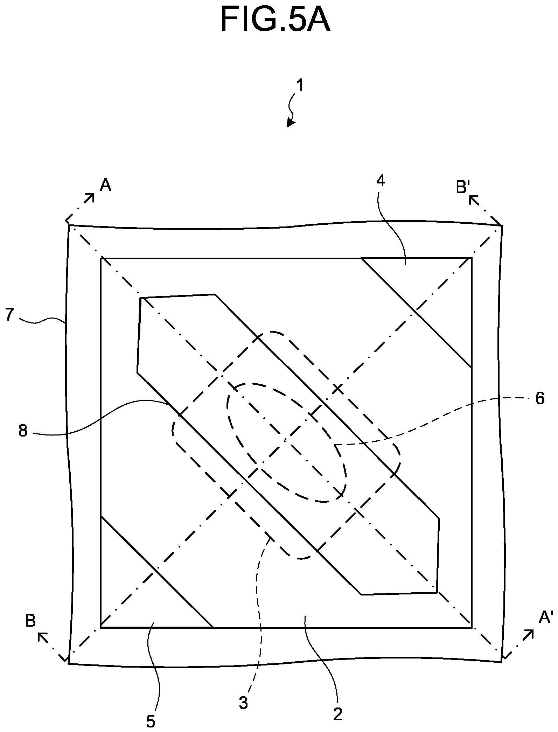

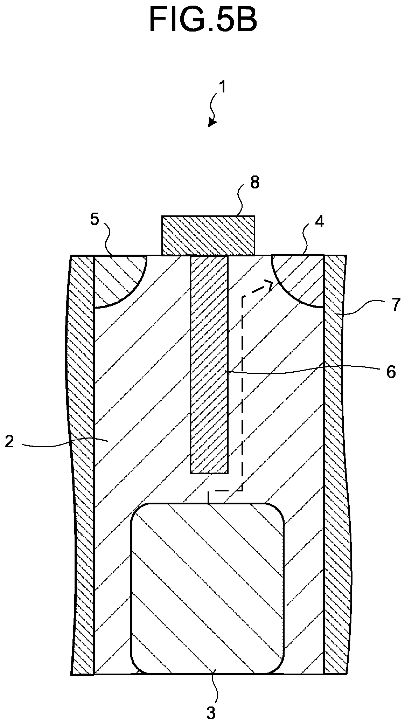

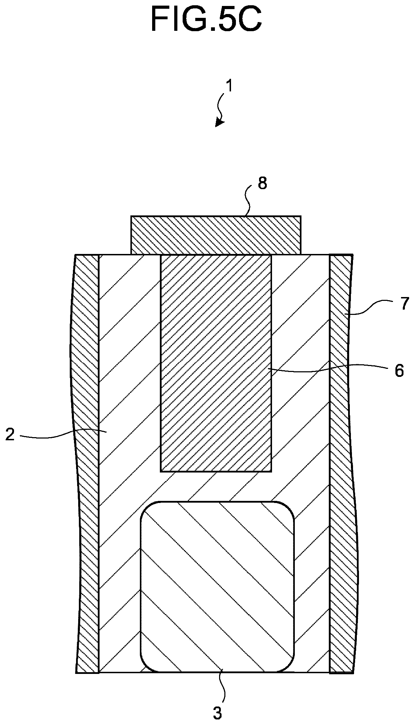

FIG. 5A is a schematic plan view of the photodetection apparatus 1 according to a first embodiment. FIG. 5B is a schematic cross-sectional side view of the photodetection apparatus 1 according to the first embodiment taken along line A-A' in FIG. 5A. FIG. 5C is a schematic cross-sectional side view of the photodetection apparatus 1 according to the first embodiment taken along line B-B' in FIG. 5A.

FIGS. 5A to 5C illustrate a portion corresponding to one pixel among a plurality of imaging pixels included in the photodetection apparatus 1 used as an imaging apparatus. The imaging pixel is, for example, a complementary metal oxide semiconductor (CMOS) image sensor adopting a vertical gate (VG) structure.

As depicted in FIGS. 5A to 5C, the photodetection apparatus 1 includes a photoelectric conversion region 3 provided in a semiconductor layer 2, a floating diffusion region (hereinafter, described as "FD region 4"), a ground region 5, and a vertical gate 6. The semiconductor layer 2 is a silicon substrate to which P-type impurities such as boron and indium are added.

As depicted in FIGS. 5B and 5C, the FD region 4 and the ground region 5 are provided on the surface layer of the semiconductor layer 2. The photoelectric conversion region 3 is provided at a position deeper than the FD region 4 and the ground region 5 in the semiconductor layer 2.

Specifically, as depicted in FIG. 5A, the FD region 4 and the ground region 5 are disposed at positions of two diagonal corners in each of partitioned regions of the semiconductor layer 2. The partitioned regions are partitioned by an element isolation region 7 for each photoelectric conversion region 3. The element isolation region 7 is, for example, a deep trench isolation (DTI) formed of an insulator such as silicon oxide.

In the photoelectric conversion region 3, the semiconductor layer 2 is doped with N-type impurities such as phosphorus. The photoelectric conversion region 3 is a photodiode formed by PN junction with the semiconductor layer 2. The photoelectric conversion region 3 photo-electrically converts light incident on the semiconductor layer 2 into signal charges in accordance with an amount of the light.

In the FD region 4, the semiconductor layer 2 is doped with N-type impurities such as phosphorus at a higher concentration than the photoelectric conversion region 3. The FD region 4 temporarily holds signal charges transferred from the photoelectric conversion region 3.

In the ground region 5, the semiconductor layer 2 is doped with P-type impurities at a higher concentration than the semiconductor layer 2. The ground region 5 is connected to the ground. Therefore, the voltages of the ground region 5 and the semiconductor layer 2, which is the same P-type diffusion region as the ground region 5, are maintained at 0 V. Incidentally, a predetermined positive voltage (for example, power supply voltage) is applied to the FD region 4.

The vertical gate 6 is provided between the FD region 4 and the ground region 5. The vertical gate 6 is disposed so as to extend in a depth direction of the semiconductor layer from a main surface of the semiconductor layer 2 toward the photoelectric conversion region 3. The vertical gate 6 is formed of, for example, conductive polysilicon. A transfer gate electrode 8 formed of polysilicon is disposed on the vertical gate 6. Incidentally, although not depicted here, a gate insulating film is provided between the vertical gate 6 and the semiconductor layer 2.

When light is incident on the semiconductor layer 2 in a state where a predetermined positive voltage is not applied to the vertical gate 6, the photodetection apparatus 1 photo-electrically converts the incident light into signal charges (electrons) by using the photoelectric conversion region 3, and accumulates the signal charges. Thereafter, when a predetermined positive voltage is applied to the vertical gate 6 via the transfer gate electrode 8, the photodetection apparatus 1 transfers the signal charges from the photoelectric conversion region 3 to the FD region 4 through a transfer path indicated by a broken line arrow in FIG. 5B. The imaging apparatus reads out the signal charges held in each of a plurality of FD regions 4 as information indicating an amount of light incident on the imaging pixel.

Here, in the photodetection apparatus 1 including the vertical gate 6, the area of the bottom surface in the vertical gate 6 is increased as the size of the vertical gate 6 is increased. When a voltage is applied to the vertical gate 6, the photodetection apparatus 1 can perform stronger modulation. This enhances efficiency of transfer of signal charges from the photoelectric conversion region 3 to the vertical gate 6.

For example, when the size of a columnar vertical gate 6 is simply increased in a minute partitioned region of the semiconductor layer 2 partitioned by the element isolation region 7, however, the distance between the vertical gate 6 and the FD region and the ground region 5 is shortened.

In the photodetection apparatus 1, the distance between the vertical gate 6 and the FD region 4 is shortened, a positive voltage is not applied to the vertical gate 6. In a state in which a positive voltage is applied to the FD region 4, a strong electric field is generated between the vertical gate 6 and the FD region 4, and the strong electric field causes generation of electrons irrelevant to incident light. When the electrons generated irrelevantly to incident light are transferred to the FD region 4 and read out as pixel signals, the electrons appear as white spots in an imaged image, and causes a deterioration in image quality.

In the photodetection apparatus 1, when the distance between the vertical gate 6 and the ground region 5 is shortened and a positive voltage is applied to the vertical gate 6, a strong electric field is generated between the vertical gate 6 and the ground region 5, and the strong electric field causes generation of electrons irrelevant to incident light. When the electrons generated irrelevantly to incident light are transferred to the FD region 4 and read out as pixel signals, the electrons appear as white spots in an imaged image, and causes a deterioration in image quality.

Thus, the photodetection apparatus 1 is configured to be able to inhibit occurrence of a white spot while improving the signal charge transfer efficiency. Specifically, as depicted in FIG. 5A, the vertical gate 6 according to the first embodiment is configured such that a cross section parallel to the main surface of the semiconductor layer 2 has an elliptical shape. The vertical gate 6 according to the first embodiment is disposed such that a side surface serving as one long surface faces the FD region 4 and a side surface serving as the other long surface faces the ground region 5.

Incidentally, the shape of the cross section parallel to the main surface of the semiconductor layer 2 in the vertical gate 6 is not limited to the elliptical shape. The cross section may have a polygonal shape as long as side surfaces serving as long surfaces are disposed so as to face the FD region 4 and the ground region 5. This causes the vertical gate 6 to have an area of a bottom surface facing the photoelectric conversion region 3 larger than that of, for example, the columnar vertical gate, so that the efficiency of transfer of signal charges from the photoelectric conversion region 3 to the vertical gate 6 can be improved.

Moreover, the vertical gate 6 is disposed between the FD region 4 and the ground region 5. The FD region 4 and the ground region 5 are disposed in a direction of extension of a minor axis in an elliptical cross section. More specifically, the vertical gate 6 is disposed at a central position between the FD region 4 and the ground region 5 in plan view.

This enables the photodetection apparatus 1 to sufficiently secure the distance between the vertical gate 6 and the FD region 4 and the ground region 5 by equally separating the vertical gate 6 from the FD region 4 and the ground region 5 in each of partitioned regions. Therefore, the photodetection apparatus 1 can inhibit occurrence of a white spot by inhibiting occurrence of a strong electric field between the vertical gate 6 and the FD region 4 and the ground region 5.

In addition, as depicted in FIG. 5A, the FD region 4 and the ground region 5 are disposed at positions of two diagonal corners in each of partitioned regions of the semiconductor layer 2. The partitioned regions are partitioned by an element isolation region 7 for each photoelectric conversion region 3.

This maximizes the distance between the vertical gate 6 and the FD region 4 and the ground region 5 in each of partitioned regions, so that the photodetection apparatus 1 can inhibit occurrence of electrons due to a strong electric field generated between the vertical gate 6 and the FD region 4 and a strong electric field generated between the vertical gate 6 and the ground region 5. Therefore, the photodetection apparatus 1 can further inhibit the occurrence of a white spot.

In addition, the transfer gate electrode 8 is stacked on an end surface on the main surface of the semiconductor layer 2 in the vertical gate 6, and the area of a cross section parallel to the main surface is larger than that of the end surface of the vertical gate 6. That is, the transfer gate electrode 8 has an area in plan view larger than an area in plan view of the vertical gate 6. This enables the photodetection apparatus 1 to easily perform alignment between the transfer gate electrode 8 and wiring in a case where the wiring to be connected to the transfer gate electrode 8 is provided.

### [3. Photodetection Apparatus According to Second Embodiment]

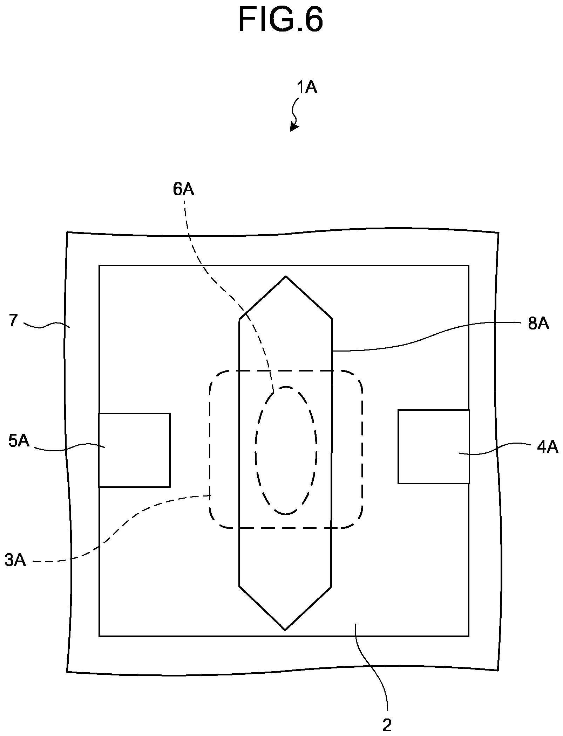

Next, a photodetection apparatus 1A according to a second embodiment will be described with reference to FIG. 6. FIG. 6 is a schematic plan view of the photodetection apparatus 1A according to the second embodiment. Here, the same components as those in FIG. 5A among components in FIG. 6 are denoted by the same reference signs as those in FIG. 5A, and duplicate description will thereby be omitted.

As depicted in FIG. 6, the photodetection apparatus 1A is different from the photodetection apparatus 1 according to the first embodiment in arrangements of a photoelectric conversion region 3A, an FD region 4A, a ground region 5A, a vertical gate 6A, and a transfer gate electrode 8A.

The FD region 4A and the ground region 5A according to the second embodiment are disposed at respective central positions of two sides facing each other in each of partitioned regions of the semiconductor layer 2. The partitioned regions are partitioned by the element isolation region 7 for each photoelectric conversion region 3A. Incidentally, as in the first embodiment, the FD region 4A and the ground region 5A are disposed on the surface layer of the semiconductor layer 2.

The photoelectric conversion region 3A is disposed between the FD region 4A and the ground region 5A in the semiconductor layer 2 in plan view. Incidentally, as in the first embodiment, the photoelectric conversion region 3A is disposed at a deeper position of the semiconductor layer 2 than the position where the FD region 4A and the ground region 5A are disposed.

As in the first embodiment, in the vertical gate 6A, a cross section parallel to the main surface of the semiconductor layer 2 has an elliptical shape, and side surfaces serving as long surfaces are disposed so as to face the FD region 4A and the ground region 5A. That is, the vertical gate 6A is disposed such that a minor axis of an elliptical cross section coincides with a straight line connecting the FD region 4A with the ground region 5A.

Consequently, in the photodetection apparatus 1A, the FD region 4A is disposed at a central position of one of two sides facing each other in each of the partitioned regions. The distance between the FD region 4A and the ground region 5A is longer than that in a case where the ground region 5A is disposed at an end of a side on which the FD region 4A is disposed in each of the partitioned regions. Therefore, the photodetection apparatus 1A can inhibit occurrence of a white spot by inhibiting occurrence of electrons due to a strong electric field generated between the FD region 4A and the ground region 5A.

### [4. Photodetection Apparatus According to Third Embodiment]

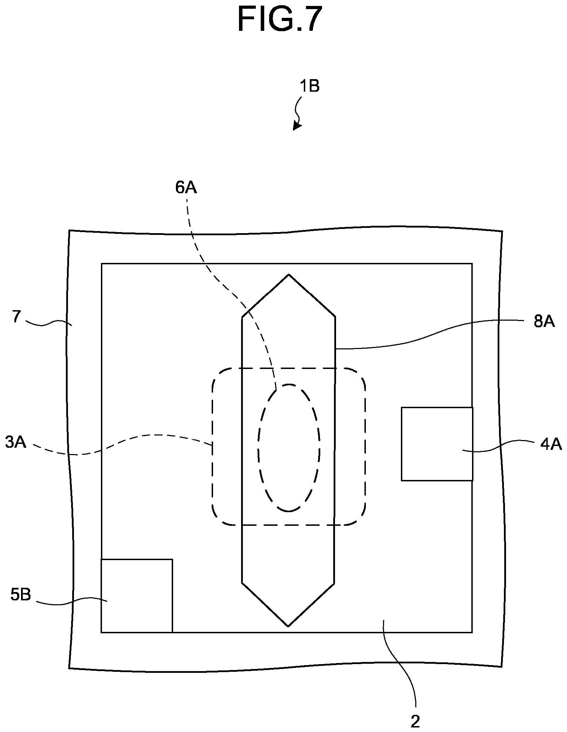

Next, a photodetection apparatus 1B according to a third embodiment will be described with reference to FIG. 7. FIG. 7 is a schematic plan view of the photodetection apparatus 1B according to the third embodiment. Here, the same components as those in FIG. 6 among components in FIG. 7 are denoted by the same reference signs as those in FIG. 6, and duplicate description will thereby be omitted.

As depicted in FIG. 7, the photodetection apparatus 1B is different from the photodetection apparatus 1A according to the second embodiment in the arrangement of a ground region 5B. Other configurations of the photodetection apparatus 1B are similar to those of the photodetection apparatus 1A according to the second embodiment. Specifically, as in the second embodiment, the FD region 4A of the third embodiment is disposed at a central position of one of two sides facing each other in each of partitioned regions of the semiconductor layer 2. The partitioned regions are partitioned by the element isolation region 7 for each photoelectric conversion region 3A.

Then, the ground region 5B according to the third embodiment is disposed at an end of the other of the two sides facing each other in each of the partitioned regions. That is, the ground region 5B is disposed at an end of a parallel side facing a side on which the FD region 4A is provided in each of the partitioned regions.

Consequently, in the photodetection apparatus 1B, the FD region 4A is disposed at a central position of one of two sides facing each other in each of the partitioned regions. The distance between the FD region 4A and the ground region 5B is longer than that in a case where the ground region 5B is disposed at an end of the same side as a side on which the FD region 4A is disposed in each of the partitioned regions. Therefore, the photodetection apparatus 1B can inhibit occurrence of a white spot by inhibiting occurrence of electrons due to a strong electric field generated between the FD region 4A and the ground region 5B.

### [5. Photodetection Apparatus According to Fourth Embodiment]

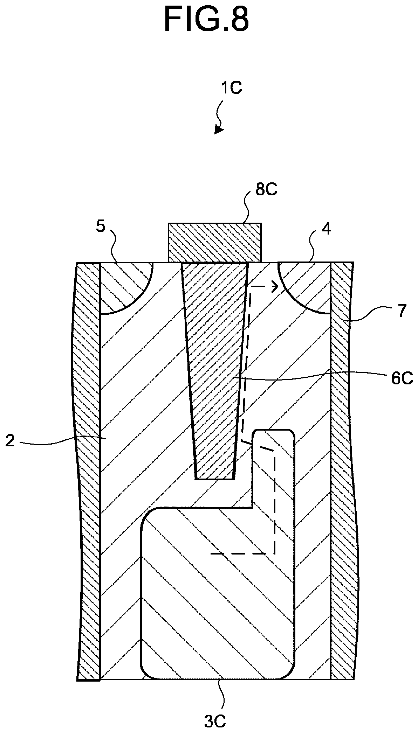

Next, a photodetection apparatus 1C according to a fourth embodiment will be described with reference to FIG. 8. FIG. 8 is a schematic cross-sectional side view of the photodetection apparatus 1C according to the fourth embodiment. Here, the same components as those in FIG. 5B among components in FIG. 8 are denoted by the same reference signs as those in FIG. 5B, and duplicate description will thereby be omitted.

As depicted in FIG. 8, the photodetection apparatus 1C has a vertical gate 6C and a photoelectric conversion region 3C having a shape different from that of the vertical gate 6 and the photoelectric conversion region 3 according to the first embodiment. Other configurations of the photodetection apparatus 1C are similar to those of the photodetection apparatus 1 according to the first embodiment. Specifically, the vertical gate 6C according to the fourth embodiment has a tapered shape tapered as a depth position in the semiconductor layer 2 is deepened.

In addition, the photoelectric conversion region 3C is expanded to a region of the semiconductor layer 2 between the element isolation region 7 and the vertical gate 6C on a side where the FD region 4 is provided. In the photodetection apparatus 1C, as indicated by a broken line arrow in FIG. 8, signal charges are transferred from a protruding portion of the photoelectric conversion region 3C expanded to a region facing a side surface of the vertical gate 6C to the FD region 4 via the side surface of the vertical gate 6C.

As described above, when a bottom surface of the vertical gate 6C is not used as a transfer path for signal charges, the photoelectric conversion region 3C can be expanded by reducing a region of the semiconductor layer 2 occupied by a tapered end portion of the vertical gate 6C. The photodetection apparatus 1C can thus improve a saturation signal charge amount.

In addition, as an area facing the FD region 4 in the vertical gate 6C is increased, modulation from the vertical gate 6C is strongly received, so that the photodetection apparatus 1C improves the signal charge transfer efficiency. Specifically, in the photodetection apparatus 1C, areas of a side surface serving as a short surface unnecessary for transfer of signal charges and a bottom surface are reduced by the vertical gate 6C having an elliptical tapered shape in horizontal cross-sectional view, and an area of a side surface serving as a long surface facing the FD region 4 important for transfer of signal charges is expanded, which improves the signal charge transfer efficiency.

### [6. Photodetection Apparatus According to Fifth Embodiment]

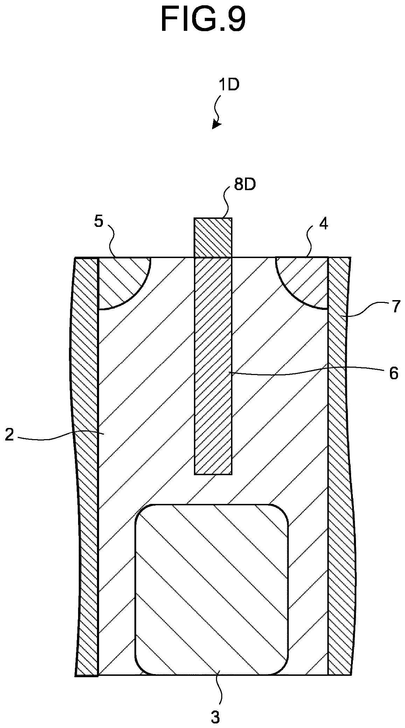

Next, a photodetection apparatus 1D according to a fifth embodiment will be described with reference to FIG. 9. FIG. 9 is a schematic cross-sectional side view of the photodetection apparatus 1D according to the fifth embodiment. Here, the same components as those in FIG. 5B among components in FIG. 9 are denoted by the same reference signs as those in FIG. 5B, and duplicate description will thereby be omitted.

As depicted in FIG. 9, the photodetection apparatus 1D has a transfer gate electrode 8D having a shape different from that of the transfer gate electrode 8 according to the first embodiment. Other configurations of the photodetection apparatus 1D are similar to those of a photodetection apparatus 1 according to the first embodiment. Specifically, the transfer gate electrode 8D according to the fifth embodiment is stacked on an end surface on the main surface of the semiconductor layer 2 in the vertical gate 6. The area of a cross section parallel to the main surface of the semiconductor layer 2 is equal to the area of a cross section parallel to the main surface of the semiconductor layer 2 in the vertical gate 6. This enables the photodetection apparatus 1D to inhibit occurrence of retention of signal charges.

For example, when the transfer gate electrode 8D protrudes toward the FD region 4 from above the vertical gate 6 in a shape of eaves, electric fields concentrate on the portion of eaves, and signal charges are retained. In the fifth embodiment, a side surface of the transfer gate electrode 8D is flush with a side surface of the vertical gate 6. This prevents the concentration of electric fields. The photodetection apparatus 1D can thus inhibit occurrence of retention of signal charges.

### [7. Effects]

The photodetection apparatus 1 includes the photoelectric conversion region 3, the FD region 4, the ground region 5, and the vertical gate 6. The photoelectric conversion region 3 is provided in the semiconductor layer 2, and converts incident light into signal charges. The FD region 4 is provided in the semiconductor layer 2, and holds signal charges transferred from the photoelectric conversion region 3. The ground region 5 is provided in the semiconductor layer 2, and connected to the ground. The vertical gate 6 is provided between the FD region 4 and the ground region 5. The vertical gate 6 is disposed such that the vertical gate 6 extends in a depth direction of the semiconductor layer 2 from a main surface of the semiconductor layer 2 toward the photoelectric conversion region 3 and a long surface faces the FD region 4. This enables the photodetection apparatus 1 to inhibit occurrence of a white spot while improving the signal charge transfer efficiency by sufficiently securing the distance between the vertical gate 6 and the FD region 4 and the ground region 5 while expanding the area of the bottom surface in the vertical gate 6.

In addition, the FD region 4 and the ground region 5 are disposed at positions of two diagonal corners in each of partitioned regions of the semiconductor layer 2. The partitioned regions are partitioned by an element isolation region 7 for each photoelectric conversion region 3. This maximizes the distance between the vertical gate 6 and the FD region 4 and the ground region 5 in each of partitioned regions, so that the photodetection apparatus 1 can inhibit occurrence of electrons due to a strong electric field generated between the vertical gate 6 and the FD region 4 and a strong electric field generated between the vertical gate 6 and the ground region 5. Therefore, the photodetection apparatus 1 can further inhibit the occurrence of a white spot.

In addition, the FD region 4A and the ground region 5A of the photodetection apparatus 1A are disposed at each of central positions of two sides facing each other in each of partitioned regions of the semiconductor layer 2. The partitioned regions are partitioned by the element isolation region 7 for each photoelectric conversion region 3A. Consequently, in the photodetection apparatus 1A, the FD region 4A is disposed at a central position of one of two sides facing each other in each of the partitioned regions. The distance between the FD region 4A and the ground region 5A is longer than that in a case where the ground region 5A is disposed at an end of a side on which the FD region 4A is disposed in each of the partitioned regions. Therefore, the photodetection apparatus 1A can inhibit occurrence of a white spot by inhibiting occurrence of electrons due to a strong electric field generated between the FD region 4A and the ground region 5A.

In addition, the FD region 4A of the photodetection apparatus 1B is disposed at a central positions of one of two sides facing each other in each of partitioned regions of the semiconductor layer 2. The partitioned regions are partitioned by the element isolation region 7 for each photoelectric conversion region 3A. The ground region 5B is disposed at an end of the other of the two sides facing each other in each of the partitioned regions. Consequently, in the photodetection apparatus 1B, the FD region 4A is disposed at a central position of one of two sides facing each other in each of the partitioned regions. The distance between the FD region 4A and the ground region 5B is longer than that in a case where the ground region 5B is disposed at an end of a side on which the FD region 4A is disposed in each of the partitioned regions. Therefore, the photodetection apparatus 1B can inhibit occurrence of a white spot by inhibiting occurrence of electrons due to a strong electric field generated between the FD region 4A and the ground region 5B.

In addition, the vertical gates 6, 6A, and 6C of the photodetection apparatuses 1, 1A, 1C, and 1D are disposed at central positions between the FD regions 4 and 4A and the ground regions 5 and 5A. This enables the photodetection apparatus 1 to sufficiently secure the distance between the vertical gate 6 and the FD region 4 and the ground region 5 by equally separating the vertical gate 6 from the FD region 4 and the ground region 5 in each of partitioned regions. The photodetection apparatus 1 can thus inhibit occurrence of a white spot.

In addition, the vertical gate 6C of the photodetection apparatus 1C has a tapered shape tapered as a depth position in the semiconductor layer 2 is deepened. Consequently, when a bottom surface of the vertical gate 6C is not used as a transfer path for signal charges, the photoelectric conversion region 3 can be expanded by reducing a region of the semiconductor layer 2 occupied by an end portion of the vertical gate 6C. The photodetection apparatus 1C can thus improve a saturation signal charge amount.

In addition, the photodetection apparatuses 1, 1A, 1B, and 1C include transfer gate electrodes 8, 8A, and 8C stacked on end surfaces on main surfaces in the vertical gates 6, 6A, and 6C and having cross sections parallel to the main surfaces of semiconductor layers 2 whose areas are larger than those of cross sections parallel to the main surfaces of the semiconductor layers 2 in the vertical gates 6, 6A, and 6C. This enables the photodetection apparatuses 1, 1A, 1B, and 1C to easily perform alignment between the transfer gate electrodes 8, 8A, and 8C and wiring to be connected to the transfer gate electrodes 8.

In addition, the photodetection apparatus 1D includes the transfer gate electrode 8D stacked on an end surface on the main surface of the semiconductor layer 2 in the vertical gate 6 and having a cross section parallel to the main surface of the semiconductor layer 2 whose area is equal to that of a cross section parallel to the main surface of the semiconductor layer 2 in the vertical gate 6. Consequently, the transfer gate electrode 8D does not protrude in the shape of eaves toward the side of the FD region 4. The photodetection apparatus 1D can inhibit retention of signal charges by inhibiting occurrence of concentration of electric fields.

### [8. Example of Application to Mobile Body]

The technology according to the present disclosure (present technology) can be applied to various products. For example, the technology according to the present disclosure may be implemented as a device mounted in a mobile body of any type of an automobile, an electric vehicle, a hybrid electric vehicle, a motorcycle, a bicycle, a personal mobility, an airplane, a drone, a ship, a robot, and the like.

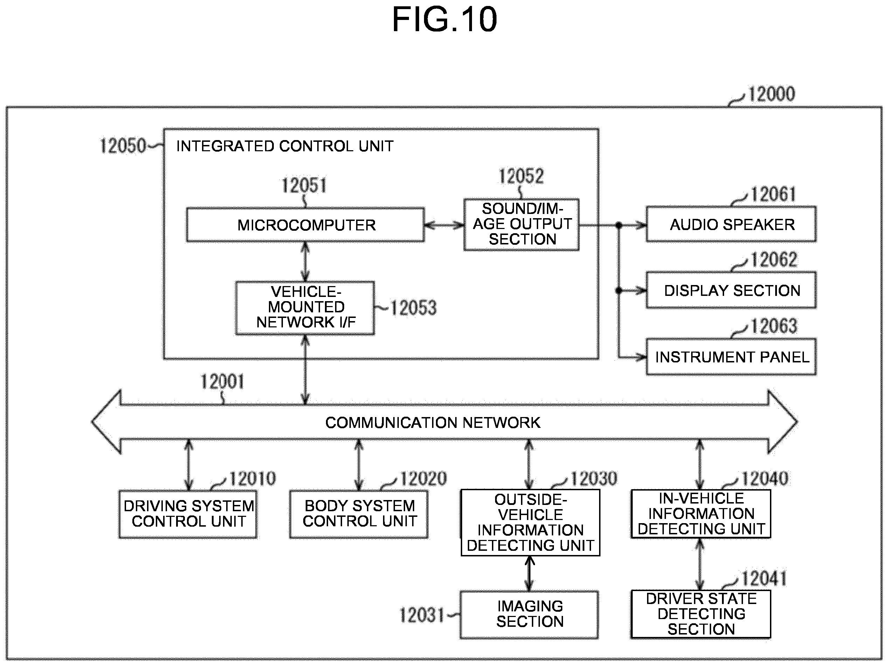

FIG. 10 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 10, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 10, an audio speaker 12061, a display section 12062, and an instrument panel 12063 are illustrated as the output device. The display section 12062 may, for example, include at least one of an on-board display and a head-up display.

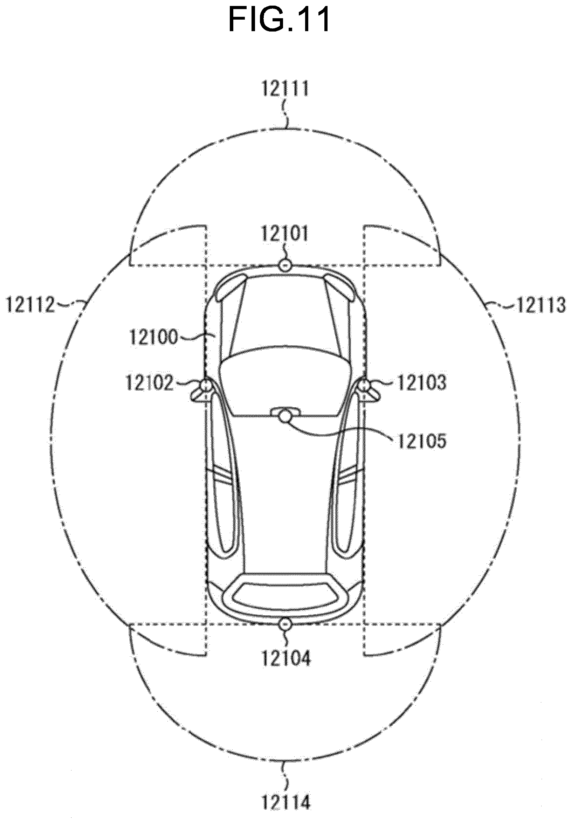

FIG. 11 is a diagram depicting an example of the installation position of the imaging section 12031.

In FIG. 11, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 11 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technology according to the present disclosure can be applied has been described above. The technology according to the present disclosure can be applied to the imaging section 12031 among the above-described configurations. An image having a good image quality can be acquired by applying the technology according to the present disclosure to the imaging section 12031. Various effects can be exhibited. For example, accuracy of various kinds of detection processes can be enhanced.

### [9. Example of Application to Endoscopic Surgery System]

The technology according to the present disclosure (present technology) can be applied to various products. For example, the technology according to the present disclosure may be applied to an endoscopic surgery system.

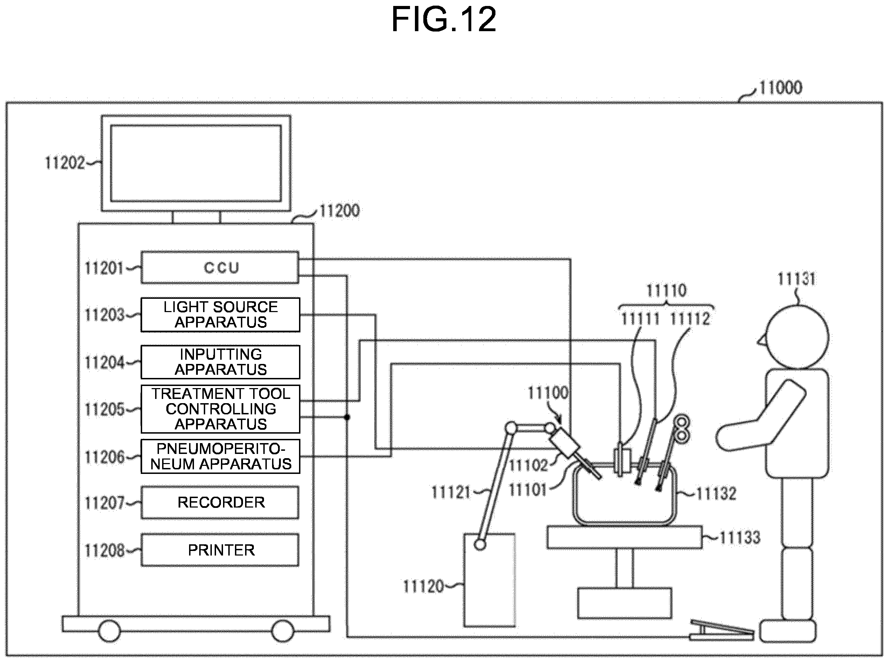

FIG. 12 is a view depicting an example of a schematic configuration of an endoscopic surgery system to which the technology according to an embodiment of the present disclosure (present technology) can be applied.

In FIG. 12, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy treatment tool 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body lumen of the patient 11132, and a camera head 11102 connected to a proximal end of the lens barrel 11101. In the example depicted, the endoscope 11100 is depicted which includes as a hard mirror having the lens barrel 11101 of the hard type. However, the endoscope 11100 may otherwise be included as a soft mirror having the lens barrel 11101 of the soft type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body lumen of the patient 11132 through the objective lens. It is to be noted that the endoscope 11100 may be a direct view mirror or may be a perspective view mirror or a side view mirror.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy treatment tool 11112 for cautery or incision of a tissue, sealing of a blood vessel or the like. A pneumoperitoneum apparatus 11206 feeds gas into a body lumen of the patient 11132 through the pneumoperitoneum tube 11111 to inflate the body lumen in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrowband light and/or excitation light suitable for special light observation as described above.

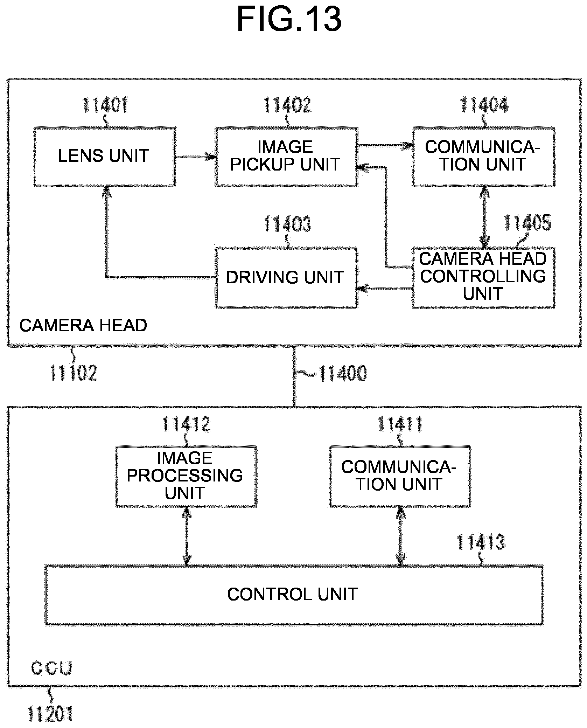

FIG. 13 is a block diagram depicting an example of a functional configuration of the camera head 11102 and the CCU 11201 depicted in FIG. 12.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy treatment tool 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

An example of the endoscopic surgery system to which the technology according to the present disclosure can be applied has been described above. The technology according to the present disclosure can be applied to, for example, the endoscope 11100, (imaging unit 11402 of) the camera head 11102, (image processing unit 11412 of) the CCU 11201 among the above-described configurations. A clearer image of a surgical region can be obtained by applying the technology according to the present disclosure to these configurations, so that the surgeon can reliably confirm the surgical region.

Incidentally, although the endoscopic surgery system has been described here in one example, the technology according to the present disclosure may be applied to, for example, a microscopic surgery system.

Although the embodiments of the present disclosure have been described above, the technical scope of the present disclosure is not limited to the above-described embodiments as it is, and various modifications can be made without departing from the gist of the present disclosure. In addition, components of different embodiments and variations may be appropriately combined.

In addition, the effects in each embodiment described in the present specification are merely examples and not limitations. Other effects may be exhibited.

Incidentally, the effects described in the present specification are merely examples and not limitations. Other effects may be obtained.

Incidentally, the present technology can also have the configurations as follows.
(1) A photodetection apparatus including:
   a photoelectric conversion region provided in a semiconductor layer;
   a floating diffusion region that is provided in the semiconductor layer and that holds a photo-electrically converted signal charge transferred from the photoelectric conversion region;
   a ground region provided in the semiconductor layer and connected to a ground; and
   a vertical gate provided between the floating diffusion region and the ground region, extending in a depth direction of the semiconductor layer from a main surface of the semiconductor layer toward the photoelectric conversion region, and disposed so as to have a long surface facing the floating diffusion region.
(2) The photodetection apparatus according to (1),
   wherein the floating diffusion region and the ground region are disposed at positions of two diagonal corners in each of partitioned regions of the semiconductor layer partitioned by an element isolation region for each photoelectric conversion region.
(3). The photodetection apparatus according to (1),
   wherein the floating diffusion region and the ground region are disposed at central positions of two sides facing each other in each of partitioned regions of the semiconductor layer partitioned by an element isolation region for each photoelectric conversion region.
(4) The photodetection apparatus according to (1),
   wherein the floating diffusion region is disposed at a central position of one of two sides facing each other in each of partitioned regions of the semiconductor layer partitioned by an element isolation region for each photoelectric conversion region, and
   the ground region is disposed at an end of the other of the two sides.
(5) The photodetection apparatus according to any one of (1) to (4),
   wherein the vertical gate is disposed at a central position between the floating diffusion region and the ground region.
(6) The photodetection apparatus according to any one of (1) to (5),
   wherein the vertical gate has a tapered shape tapered as a depth position in the semiconductor layer is deepened.
(7) The photodetection apparatus according to any one of (1) to (6), further including a transfer gate electrode stacked on an end surface on the main surface in the vertical gate and having a cross section parallel to the main surface whose area is larger than an area of a cross section parallel to the main surface.
(8) The photodetection apparatus according to any one of (1) to (6), further including a transfer gate electrode stacked on an end surface on the main surface in the vertical gate and having a cross section parallel to the main surface whose area is equal to an area of a cross section parallel to the main surface.

### Reference Signs List

1, 1A, 1B, 1C, 1D PHOTODETECTION APPARATUS
2 SEMICONDUCTOR LAYER
3, 3A, 3C PHOTOELECTRIC CONVERSION REGION
4, 4A FD REGION
5, 5A, 5B GROUND REGION
6, 6A, 6C VERTICAL GATE
7 ELEMENT ISOLATION REGION
8, 8A, 8C, 8D TRANSFER GATE ELECTRODE
12 PIXEL
13 PIXEL ARRAY SECTION
14 VERTICAL DRIVE CIRCUIT
15 COLUMN SIGNAL PROCESS CIRCUIT
16 HORIZONTAL DRIVE CIRCUIT
17 OUTPUT CIRCUIT
18 CONTROL CIRCUIT
10 FIRST SUBSTRATE
11, 21, 31, ST SEMICONDUCTOR SUBSTRATE
20 SECOND SUBSTRATE
22 READOUT CIRCUIT
23 PIXEL DRIVE LINE
24 VERTICAL SIGNAL LINE
30 THIRD SUBSTRATE
32 LOGIC CIRCUIT
101 ELECTRONIC DEVICE
102 OPTICAL SYSTEM
103 PHOTODETECTION APPARATUS
104 DSP
105 DISPLAY APPARATUS
106 OPERATION SYSTEM
107 BUS
108 MEMORY
109 RECORDING APPARATUS
110 POWER SUPPLY SYSTEM

## Claims

1. A photodetection apparatus comprising:
a photoelectric conversion region that is provided in a semiconductor layer and that converts incident light into a signal charge;
a floating diffusion region that is provided in the semiconductor layer and that holds the signal charge transferred from the photoelectric conversion region;
a ground region provided in the semiconductor layer and connected to a ground; and
a vertical gate provided between the floating diffusion region and the ground region, extending in a depth direction of the semiconductor layer from a main surface of the semiconductor layer toward the photoelectric conversion region, and disposed so as to have a long surface facing the floating diffusion region.

2. The photodetection apparatus according to claim 1,
wherein the floating diffusion region and the ground region are disposed at positions of two diagonal corners in each of partitioned regions of the semiconductor layer partitioned by an element isolation region for each photoelectric conversion region.

3. The photodetection apparatus according to claim 1,
wherein the floating diffusion region and the ground region are disposed at central positions of two sides facing each other in each of partitioned regions of the semiconductor layer partitioned by an element isolation region for each photoelectric conversion region.

4. The photodetection apparatus according to claim 1,
wherein the floating diffusion region is disposed at a central position of one of two sides facing each other in each of partitioned regions of the semiconductor layer partitioned for each photoelectric conversion region, and
the ground region is disposed at an end of another of the two sides.

5. The photodetection apparatus according to claim 1,
wherein the vertical gate is disposed at a central position between the floating diffusion region and the ground region.

6. The photodetection apparatus according to claim 1,
wherein the vertical gate has a tapered shape tapered as a depth position in the semiconductor layer is deepened.

7. The photodetection apparatus according to claim 1, further comprising a transfer gate electrode stacked on an end surface on the main surface in the vertical gate and having a cross section parallel to the main surface whose area is larger than an area of a cross section parallel to the main surface.

8. The photodetection apparatus according to claim 1, further comprising a transfer gate electrode stacked on an end surface on the main surface in the vertical gate and having a cross section parallel to the main surface whose area is equal to an area of a cross section parallel to the main surface.
